(19) Europäisches Patentamt
European Patent Office
Office européen des brevets

(11) **EP 4 660 231 A1**

(12) **EUROPEAN PATENT APPLICATION**

(43) Date of publication:
**10.12.2025 Bulletin 2025/50**

(21) Application number: 24180468.1

(22) Date of filing: **06.06.2024**

(51) International Patent Classification (IPC):
***C08K 3/26*** (2006.01)   ***C08L 23/08*** (2025.01)
***H01L 31/048*** (2014.01)

(52) Cooperative Patent Classification (CPC):
(C-Sets available)
**C08L 23/0815; C08K 3/26; H10F 19/804**   (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Borealis GmbH**
**1020 Vienna (AT)**

(72) Inventors:
• **HELLSTRÖM, Stefan**
**444 86 Stenungsund (SE)**
• **CHENG, Joy Jie**
**4021 Linz (AT)**
• **DOU, Qizheng**
**4021 Linz (AT)**
• **HAGSTRAND, Per-Ola**
**444 86 Stenungsund (SE)**
• **SMEDBERG, Annika**
**444 86 Stenungsund (SE)**
• **ENGLUND, Villgot**
**444 86 Stenungsund (SE)**

(74) Representative: **Kador & Partner Part mbB**
**Corneliusstraße 15**
**80469 München (DE)**

(54) **ETHYLENE COPOLYMERS WITH IMPROVED VOLUME RESISTIVITY**

(57)    The invention concerns a polyolefin encapsulant composition comprising an ethylene-alpha-olefin copolymer (A), wherein the alpha-olefin has 4 to 8 carbon atoms, and a hydrotalcite compound (B), wherein the ethylene- alpha-olefin copolymer (A) has a density in the range of 850 kg/m$^3$ to 900 kg/m$^3$ measured according to ISO 1183, and a melt flow rate MFR$_2$ (190°C, 2.16 kg) in the range of from 0.3 g/10 min to 45 g/10 min measured according to ISO 1133, and wherein the hydrotalcite compound (B) is present in an amount of from 0.01 to 5 wt.% based on the total weight of the polyolefin encapsulant composition.

EP 4 660 231 A1

(52) Cooperative Patent Classification (CPC): (Cont.)

C-Sets
**C08K 3/26, C08L 23/0815**

**Description**

The present invention concerns ethylene-alpha-olefin copolymers having improved volume resistivity, particularly ethylene-1-octene copolymers having improved volume resistivity.

In view of the present climate changes sustainable energy is receiving increasing attention. Solar cells and solar modules can deliver sustainable energy by converting the energy of light directly into electricity. Continuous efforts to increase the power output of solar modules has led to development of several new high-efficiency cell technologies which rapidly are gaining market shares. These cell technologies require high-quality encapsulants to protect the solar cells from various forms of degradation including potential-induced degradation (PID). This development has led to polyolefin elastomer encapsulant (POE) gaining market share over traditional ethylene-vinyl acetate (EVA) encapsulants due to high volume resistivity and low moisture diffusion of the POE encapsulants. However, the POE resins need to have high volume resistivities (VR) to qualify as encapsulant composition for solar cells and solar modules.

Furthermore, the encapsulants for solar cells should be recyclable for environmental benefits.

WO 2013/186992 relates to a solar cell encapsulant and a solar cell module. The solar cell encapsulant contains an ethylene alpha-olefin copolymer, an organic peroxide and an acid acceptor. The acid acceptor can be selected from magnesium hydroxide, magnesium oxide, zinc oxide, trilead tetroxide, calcium hydroxide, aluminium hydroxide, iron (II) hydroxide, calcium carbonate and/or a hydrotalcite compound. It was found that the solar cell encapsulant has improved adhesion to the metal electrode and solder and can maintain adhesion for a long period of time even under constant temperature and humidity conditions.

WO 2012/150285 discloses a polymer composition for an insulating layer of a power cable. The crosslinked polymer composition can be a HDPE/LDPE blend comprising synthetic hydrotalcite as ion exchanger additive and is characterized by a very low electrical conductivity.

WO 2012/150287 discloses a polymer composition for an insulating layer of a high voltage power cable applications. The crosslinked polymer composition comprises LDPE and synthetic hydrotalcite as ion exchanger additive and is characterized by a low electrical conductivity.

A polymer composition for an insulating layer of a high voltage power cable applications is also disclosed in WO 2012/150286. The crosslinked polymer composition comprises HDPE and synthetic hydrotalcite as ion exchanger additive and is characterized by a low electrical conductivity.

There remains a need for an encapsulant composition having a high volume resistivity and being at the same time recyclable.

It is thus an object of the invention to provide a polyolefin encapsulant composition having a high volume resistivity (VR).

It is a further object of the invention that the polyolefin encapsulant composition is recyclable.

The invention thus provides a polyolefin encapsulant composition comprising an ethylene-alpha-olefin copolymer (A), wherein the alpha-olefin has 4 to 8 carbon atoms, preferably 4 or 8 carbon atoms, most preferably 8 carbon atoms, and a hydrotalcite compound (B), the hydrotalcite compound (B) preferably comprising, or consisting of, a synthetic hydrotalcite compound,

wherein the ethylene-alpha-olefin copolymer (A) has

a density in the range of 850 kg/m$^3$ to 900 kg/m$^3$ measured according to ISO 1183, and

a melt flow rate MFR$_2$ in the range of from 0.3 g/10 min to 45 g/10 min measured according to ISO 1133 at 190°C with a load of 2.16 kg, and

wherein the hydrotalcite compound (B) is present in an amount of 0.01 to 5 wt.% based on the total weight of the polyolefin encapsulant composition.

The present invention has several advantages. A high volume resistivity (VR) of the solar cell encapsulant composition of the invention leads to a significantly reduced degradation including potential-induced degradation (PID). Furthermore, the high volume resistivity (VR) is achieved in a nimble and cost efficient way. In addition to that the polyolefin encapsulant composition according to the invention is recyclable as the polymeric part of the polyolefin encapsulant composition only comprises olefin units.

The ethylene-alpha-olefin copolymer (A) according to the invention is a copolymer of ethylene as monomer and an alpha olefin having 4 to 8 carbon atoms as comonomer. The alpha-olefin having from 4 to 8 carbon atoms encompasses butene, pentene, hexene, heptene and octene, respectively.

Preferably the alpha-olefin has 4 or 8 carbon atoms, more preferably the alpha-olefin is 1-butene or 1-octene, even more preferably 1-octene. Thus, the ethylene-alpha-olefin copolymer (A) is preferably ethylene-1-butene or ethylene-1-octene copolymer, more preferably ethylene-1-octene copolymer.

Preferably the ethylene-alpha-olefin copolymer (A) has a density in the range of 860 kg/m$^3$ to 890 kg/m$^3$, more preferably in the range of 862 kg/m$^3$ to 885 kg/m$^3$, most preferably in the range of 865 kg/m$^3$ to 880 kg/m$^3$ measured according to ISO 1183.

Preferably the ethylene-alpha-olefin copolymer (A) has a melt flow rate MFR$_2$ in the range of from 0.5 g/10 min to 40 g/10 min, more preferably in the range of from 1.0 g/10 min to 35 g/10 min, even more preferably in the range of from 2.0 g/10 min to 30 g/10 min, and most preferably in the range of from 3.0 g/10 min to 20 g/10 min measured according to ISO 1133 at 190°C with a load of 2.16 kg.

Preferably the ethylene-alpha-olefin copolymer (A) has a melt flow rate MFR$_{21}$ in the range of from 50 g/10 min to 450 g/10 min, more preferably in the range of from 100 g/10 min to 400 g/10 min, more preferably in the range of from 120 g/10 min to 350 g/10 min, and most preferably in the range of from 150 g/10 min to 300 g/10 min measured according to ISO 1133 at 190°C with a load of 21.6 kg.

Preferably the ethylene-alpha-olefin copolymer (A) has a flow rate ratio FRR$_{21/2}$ of from 20.0 to 45.0, more preferably of from of from 22.0 to 42.0, and most preferably of from 24.0 to 40.0, measured according to ISO 1133.

In an embodiment of the present invention, the ethylene-alpha-olefin copolymer (A) as defined above, can also be a blend of two ethylene-alpha-olefin copolymers (A) having different melt flow rate MFR$_2$ and/or different densities within the above-described ranges.

For example, the ethylene-alpha-olefin copolymer (A) can be a blend of an ethylene-alpha-olefin copolymer (A-1) having a MFR$_2$ of 5 g/10 min and an ethylene-alpha-olefin copolymer (A-2) having a MFR$_2$ of 14 g/10 min.

Preferably, the ethylene-alpha-olefin copolymer (A) is present in an amount of from 90 to 99.95 wt.% based on the total weight of the polyolefin encapsulant composition.

Preferably, units originating from the alpha-olefin are present in an amount of 25 to 45 wt.%, more preferably 28 to 40 wt.%, even more preferably 30 to 36 wt.%, based on the total weight of the ethylene-alpha-olefin copolymer (A).

Preferably the ethylene-alpha-olefin copolymer (A) has a Mw/Mn of from 1.0 to 6.0, more preferably of from 1.5 to 5.0, and most preferably of from 2.0 to 3.5.

The ethylene-alpha-olefin (A) according to the invention is preferably further characterized by its content of unsaturated groups per 100,000 carbon atoms (C atoms). These unsaturated groups are vinylidene groups ($R_2C=CH_2$), vinyl groups ($RHC=CH_2$), trisubstituted vinylene groups ($R_2C=CHR$) and vinylene groups ($RHC=CHR$).

Preferably the ethylene-alpha-olefin (A) has a) 1.0 to 20.0, more preferably 3.0 to 15.0 vinyl unsaturation units / 100,000 C atoms, even more preferably 5.0 to 12.5 vinyl unsaturation units / 100,000 C atoms measured by 1H NMR.

Preferably the ethylene-alpha-olefin (A) has b) 5.0 to 30.0, more preferably 7.0 to 25.0 vinylidene unsaturation units / 100,000 C, even more preferably 7.5 to 20.5 vinylidene unsaturation units / 100,000 C atoms measured by 1H NMR.

Preferably the ethylene-alpha-olefin (A) has c) 2.0 to 15.0 more preferably 2.5 to 14.0 vinylene unsaturation units / 100,000 C atoms, even more preferably 3.0 to 12.0 vinylene unsaturation units / 100,000 C atoms measured by 1H NMR.

Preferably the ethylene-alpha-olefin (A) has d) 5.0 to 35.0, more preferably 6.0 to 30.0 trisubstituted unsaturation units / 100,000 C, even more preferably 8.0 to 28.0 trisubstituted unsaturation units / 100,000 C atoms measured by 1H NMR.

Preferably the ethylene-alpha-olefin (A) has e) 15.0 to 100.0, more preferably 20.0 to 80.0 total unsaturation units /100,000 C atoms, even more preferably 22.0 to 78.0 total unsaturation units /100,000 C atoms, most preferably 25.0 to 72.0 total unsaturation units /100,000 C atoms, wherein the total unsaturation units / 100,000 C atoms is the sum of vinyl unsaturation units / 100,000 C atoms, vinylidene unsaturation units / 100,000 C atoms, vinylene unsaturation units / 100,000 C atoms and trisubstituted unsaturation units / 100,000 C atoms, all measured by 1H NMR.

Preferably the ethylene-alpha-olefin copolymer (A) has f) an unsaturation degree according to formula (2)

$$unsaturation_{Type}\ degree\ (\%) = \frac{unsaturation_{Type}\ units\ /\ 100,000\ C\ atoms}{total\ unsaturation\ units / 100,000\ C\ atoms} * 100$$

$$(2)$$

wherein

a vinyl unsaturation degree is in the range of from 7.0 to 27.0 %, preferably of from 10.0 to 24.0 %,
a vinylene unsaturation degree is in the range of from 5.0 to 18.0 %, preferably of from 6.0 to 15.0%, and
wherein the sum of the vinyl unsaturation degree and vinylidene unsaturation degree is in the range of from 30.0% up to 60.0%.

Preferably the vinylidene unsaturation degree is in the range of from 25.0 to 38.0 %, and/or wherein the trisubstituted unsaturation degree is in the range of from 30.0 to 45.0 %.

The copolymers according to the invention can be preferably produced in a high temperature solution polymerization process at temperatures higher than 160°C, preferably at least 165°C. Such a process is essentially based on polymerizing the monomer, i.e. ethylene, and a suitable comonomer, i.e. a C4 to C8 alpha-olefin, preferably 1-butene or 1-octene, in a hydrocarbon solvent, being liquid under the polymerization conditions and in which the resulting polymer is soluble. The polymerization is carried out at a temperature above the melting point of the polymer, as a result of which a polymer solution is obtained. This solution is preferably flashed in multiple steps in order to separate the polymer from the unreacted monomer and the solvent. The solvent is then recovered and recycled in the process.

A solution polymerization process is known for its short reactor residence times (compared to Gas-phase or slurry processes) allowing, thus, very fast grade transitions and significant flexibility in producing a wide product range in a short production cycle.

The used solution polymerization process is a high temperature solution polymerization process, using a polymerization temperature of higher than 160°C. Preferably the polymerization temperature is at least 165°C, more preferably at least 168°C, and most preferably at least 170°C. The polymerization temperature can be up to 250°C.

The inlet temperature of the reactor feed is typically between -40 to +30°C, preferably -38 to +10°C, more preferably -35 to -25°C.

The pressure in the reactor depends on the temperature, on one hand, and the type and the amount of the comonomer, on the other hand. The pressure is suitably from 40 to 300 bar, preferably from 45 to 250 bar and more preferably from 50 to 200 bar.

The process includes one or more polymerization reactors. Suitable reactors include unstirred or stirred, spherical, cylindrical and tank-like vessels and recirculating loop reactors and tubular reactors. Such reactors typically include feeding points for monomer, optional comonomer, solvent, catalyst and optional other reactants and additives and withdrawal points for polymer solutions. In addition, the reactors may include heating or cooling means.

The hydrocarbon solvent used is preferably a $C_{5\text{-}12}$-hydrocarbon which may be unsubstituted or substituted by $C_{1\text{-}4}$ alkyl group such as pentane, methyl pentane, hexane, heptane, octane, cyclohexane, methylcyclohexane and hydrogenated naphtha. More preferably, unsubstituted $C_{6\text{-}10}$-hydrocarbon solvents are used.

The solution concentration in the reactor by outlet conditions is typically in the range of 20.0 to 26.0 wt.% of polymer produced, preferably 22.0 to 25.0 wt.% of polymer produced.

Typically, the residence time in the reactor is below 20 min, like 5 to 15 min.

In addition, other components may be added into the reactor. It is known to feed hydrogen into the reactor for controlling the molecular weight of the polymer formed during the polymerization. The use of different antifouling compounds is also already known in the art. In addition, different kinds of activity boosters or activity retarders may be used for controlling the activity of the catalyst.

A suitable solution polymerization process is the Borceed™ polymerization process (former called Compact polymerization process).

In another embodiment suitable polymers for the ethylene-alpha-olefin (A) are commercially available from Borealis under the tradename Queo, e.g. Queo™ 7007.

The polyolefin encapsulant composition also comprises a hydrotalcite compound (B) in an amount of 0.01 to 5.0 wt.%, based on the total weight of the composition. Preferably, the hydrotalcite compound (B) is represented by formula (1)

$$Mg_x R_y^{3+}(OH)_z(CO_3)_k \cdot nH_2O \qquad (1)$$

wherein $R^{3+}$ is selected from Al, Cr or Fe,

$4 \le x \le 6$, y = 2, $6 \le z \le 18$, k = 1 and $3 \le n \le 4$,

more preferably the hydrotalcite compound (B) is represented by formula (1) and $R^{3+}$ is selected from Al, $4 \le x \le 6$, y = 2, $6 \le z \le 18$, k = 1 and $3 \le n \le 4$.

Preferably the hydrotalcite compound (B) comprises, or consists of, synthetic hydrotalcite having CAS number 11097-59-9.

Preferably, the hydrotalcite compound (B) has a BET surface of from 1 to 20 $m^2/g$ determined according to ISO 9277.

Preferably, the hydrotalcite compound (B) is present in an amount of from 0.05 to 3.0 wt.%, more preferably in an amount of from 0.1 to 2.5 wt.%, even more preferably in an amount of from 0.2 to 2.2 wt.%, and most preferably in an amount of from 0.25 to 2.0 wt.%, based on the total weight of the polyolefin encapsulant composition.

The polyolefin encapsulant composition can be prepared e.g. by dosing the hydrotalcite compound (B) in-line, subsequently to the polymerization step, e.g. to the extruder, as well as by off-line blending.

Both methods are known to art skilled persons.

In addition, the hydrotalcite compound (B) can be added in both methods as such or via a masterbatch composition comprising a carrier polymer and the hydrotalcite compound (B).

In case the ethylene-alpha-olefin copolymer (A) is a blend of two different ethylene-alpha-olefin copolymers (A), i.e. (A-1) and (A-2), the hydrotalcite compound (B) can be added to each of the copolymers (A-1) and (A-2) separately before blending them, or the hydrotalcite compound (B) is added after blending the two different ethylene-alpha-olefin copolymers (A), i.e. (A-1) and (A-2).

Preferably the polyolefin encapsulant composition does not comprise an organic peroxide.

The polyolefin encapsulant composition preferably further comprises one or more additives. The additive can be an antioxidant, such as a sterically hindered phenol, or an antistatic agent. Typically, the total amount of additives is not more than 1.0 wt.%, preferably in the range of 0.05 to 1.0 wt.%, based on the total weight of the polyolefin encapsulant composition.

Preferably the polyolefin encapsulant composition has a volume resistivity according to the method as described in the experimental part applying 1000 V and a test time of 10 minutes, of at least $1.0 \cdot 10^{15} \, \Omega \cdot cm$, more preferably of at least $1.1 \cdot 10^{15} \, \Omega \cdot cm$.

The invention further provides an article comprising the polyolefin encapsulant composition according to the invention, wherein the polyolefin encapsulant composition is preferably crosslinked. Crosslinking of polyolefin compositions using e.g. irradiation or peroxides is known in the art.

Preferably, the article is a solar module.

The invention further provides the use of a hydrotalcite compound (B) for improving the volume resistivity of a polyolefin encapsulant composition comprising an ethylene-alpha-olefin copolymer (A).

All preferred embodiments of the polyolefin encapsulant composition according to the invention are also preferred embodiments of the use according to the invention.

Preferably, the hydrotalcite compound (B) is present in an amount of from 0.25 to 2.0 wt.% based on the total weight of the polyolefin encapsulant composition.

**Experimental Part**

**1. Measurement methods**

The measurement methods apply to the parameters mentioned in the description of the invention and the examples below.

*a) Melt Flow Rate and Flow Rate Ratio*

The melt flow rate (MFR) was determined according to ISO 1133 and is indicated in g/10 min. The MFR is an indication of the melt viscosity of the polymer. The MFR was determined at 190 °C for polyethylene with a load of 2.16 kg ($MFR_2$), 5.0 kg ($MFR_5$) or 21.6 kg ($MFR_{21}$).

The flow rate ratio $FRR_{21/2}$ is the $MFR_{21}/MFR_2$.

*b) Density*
The density of the copolymer was measured according to ISO 1183 (method A) on compression moulded specimen prepared according to EN ISO 1872-2 (Feb 2007) and is given in $kg/m^3$.

c) Determination of the Molecular weight averages, molecular weight distribution
Molecular weight averages (Mz, Mw and Mn), Molecular weight distribution (MWD) and its broadness, described by polydispersity index, PDI = Mw/Mn (wherein Mn is the number average molecular weight and Mw is the weight average molecular weight) were determined by Gel Permeation Chromatography (GPC) according to ISO 16014-1:2003, ISO 16014-2:2003, ISO 16014-4:2003 and ASTM D 6474-12 using the following formulas:

$$M_n = \frac{\sum_{i=1}^{N} A_i}{\sum_{i=1}^{N} (A_i/M_i)} \quad (1)$$

$$M_W = \frac{\sum_{i=1}^{N}(A_i x\, M_i)}{\sum_{i=1}^{N} A_i} \qquad (2)$$

$$M_Z = \frac{\sum_{i=1}^{N}(A_i\, x\, M_i^2)}{\sum_{i=1}^{N}(A_i/M_i)} \qquad (3)$$

For a constant elution volume interval $\Delta V_i$, where $A_i$, and $M_i$ are the chromatographic peak slice area and polyolefin molecular weight (MW), respectively associated with the elution volume, $V_i$, where N is equal to the number of data points obtained from the chromatogram between the integration limits.

A high temperature GPC instrument, equipped with a multiple band infrared detector model IR5 (PolymerChar, Valencia, Spain), equipped with 3 x Agilent-PLgel Olexis and 1x Agilent-PLgel Olexis Guard columns was used. As the solvent and mobile phase 1,2,4-trichlorobenzene (TCB) stabilized with 250 mg/L 2,6-Di tert butyl-4-methyl-phenol) was used. The chromatographic system was operated at 160 °C at a constant flow rate of 1 mL/min. 200 μL of sample solution was injected per analysis. Data collection was performed by using PolymerChar GPC-one software.

The column set was calibrated using universal calibration (according to ISO 16014-2:2003) with 19 narrow MWD polystyrene (PS) standards in the range of 0,5 kg/mol to 11 500 kg/mol. The PS standards were dissolved at room temperature over several hours. The conversion of the polystyrene peak molecular weight to polyethylene molecular weights is accomplished by using the Mark Houwink equation and the following Mark Houwink constants:

$$K_{PS} = 19\ x\ 10^{-3}\ mL/g, \qquad \alpha_{PS} = 0.655$$

$$K_{PE} = 39\ x\ 10^{-3}\ mL/g, \qquad \alpha_{PE} = 0.725$$

A third order polynomial fit was used to fit the calibration data.

All samples were prepared in the concentration range of 0.5 to 1 mg/ml and dissolved at 160°C for 3 hours under continuous gentle shaking.

*d) Volume resistivity (VR)*

A plaque of 100x100 mm and 0.5 mm thickness was pressed with a Teflon film at 150°C with a 1 minute preheat step at 120°C, followed by 4 minutes of temperature ramp up to 150°C with a pressure of 613 N/cm². This was held for 8 minutes and then the temperature is ramped down to 35°C in a sequence of 15°C per minute.

The plaque is then conditioned at 23°C and 50% relative humidity (RH) for at least 48h before the VR testing is performed.

The VR is performed at 1000V for 10 minutes and measurements are taken at 1 minute, 2 minutes, 5 minutes and 10 minutes. The current is measured at all these times and the volume resistivity at each time is calculated from this data according to the equation below, the unit of the VR being $\Omega\cdot cm$.

$$VR = \frac{voltage \cdot electrode\ area}{average\ current \cdot thickness\ of\ the\ plaque}$$

*e) Comonomer content*

Quantitative nuclear-magnetic resonance (NMR) spectroscopy was used to quantify the comonomer content of the polymers.

Quantitative $^{13}C\{^1H\}$ NMR spectra recorded in the molten-state using a Bruker Avance III 500 NMR spectrometer operating at 500.13 and 125.76 MHz for $^1H$ and $^{13}C$ respectively. All spectra were recorded using a $^{13}C$ optimised 7 mm magic-angle spinning (MAS) probehead at 150°C using nitrogen gas for all pneumatics. Approximately 200 mg of material was packed into a 7 mm outer diameter zirconia MAS rotor and spun at 4 kHz. This setup was chosen primarily for the high sensitivity needed for rapid identification and accurate quantification. Standard single-pulse excitation was employed utilising the transient NOE at short recycle delays of 3s and the RS-HEPT decoupling scheme. A total of 1024 (1k) transients were acquired per spectrum.

Quantitative $^{13}C\{^1H\}$ NMR spectra were processed, integrated and quantitative properties determined using custom spectral analysis automation programs. All chemical shifts are internally referenced to the bulk methylene signal ($\delta$ +) at 30.00 ppm.

Characteristic signals corresponding to the incorporation of 1-octene were observed and all comonomer contents calculated with respect to all other monomers present in the polymer.

Characteristic signals resulting from isolated 1-octene incorporation, i.e. EEOEE comonomer sequences, were observed. Isolated 1-octene incorporation was quantified using the integral of the signal at 38.3 ppm. This integral is assigned to the unresolved signals corresponding to both *B6 and $_*$bB6B6 sites of isolated (EEOEE) and isolated double non-consecutive (EEOEOEE) 1-octene sequences respectively. To compensate for the influence of the two $_*$bB6B6 sites the integral of the bbB6B6 site at 24.6 ppm is used:

$$O = I_{*B6+*bB6B6} - 2 * I_{bbB6B6}$$

Characteristic signals resulting from consecutive 1-octene incorporation, i.e. EEOOEE comonomer sequences, were also observed. Such consecutive 1-octene incorporation was quantified using the integral of the signal at 40.4 ppm assigned to the aaB6B6 sites accounting for the number of reporting sites per comonomer:

$$OO = 2 * I_{aaB6B6}$$

Characteristic signals resulting from isolated non-consecutive 1-octene incorporation, i.e. EEOEOEE comonomer sequences, were also observed. Such isolated non-consecutive 1-octene incorporation was quantified using the integral of the signal at 24.6 ppm assigned to the bbB6B6 sites accounting for the number of reporting sites per comonomer:

$$OEO = 2 * I_{bbB6B6}$$

Characteristic signals resulting from isolated triple-consecutive 1-octene incorporation, i.e. EEOOOEE comonomer sequences, were also observed. Such isolated triple-consecutive 1-octene incorporation was quantified using the integral of the signal at 41.2 ppm assigned to the aagB6B6B6 sites accounting for the number of reporting sites per comonomer:

$$OOO = 3/2 * I_{aagB6B6B6}$$

With no other signals indicative of other comonomer sequences observed the total 1-octene comonomer content was calculated based solely on the amount of isolated (EEOEE), isolated double-consecutive (EEOOEE), isolated non-consecutive (EEOEOEE) and isolated triple-consecutive (EEOOOEE) 1-octene comonomer sequences:

$$O_{total} = O + OO + OEO + OOO$$

Characteristic signals resulting from saturated end-groups were observed. Such saturated end-groups were quantified using the average integral of the two resolved signals at 22.9 and 32.23 ppm. The 22.84 ppm integral is assigned to the unresolved signals corresponding to both 2B6 and 2S sites of 1-octene and the saturated chain end respectively. The 32.2 ppm integral is assigned to the unresolved signals corresponding to both 3B6 and 3S sites of 1-octene and the saturated chain end respectively. To compensate for the influence of the 2B6 and 3B6 1-octene sites the total 1-octene content is used:

$$S = (1/2)*( I_{2S+2B6} + I_{3S+3B6} - 2*O_{total})$$

The ethylene comonomer content was quantified using the integral of the bulk methylene (bulk) signals at 30.00 ppm. This integral included the D and 4B6 sites from 1-octene as well as the $D^D$ sites. The total ethylene comonomer content was calculated based on the bulk integral and compensating for the observed 1-octene sequences and end-groups:

$$E_{total} = (1/2)*[ I_{bulk} + 2*O + 1*OO + 3*OEO + 0*OOO + 3*S ]$$

It should be noted that compensation of the bulk integral for the presence of isolated triple-incorporation (EEOOOEE) 1-octene sequences is not required as the number of under and over accounted ethylene units is equal.

The total mole fraction of 1-octene in the polymer was then calculated as:

$$fO = O_{total} / ( E_{total} + O_{total} )$$

The total comonomer incorporation of 1-octene in weight percent was calculated from the mole fraction in the standard manner:

$$O [wt\%] = 100 * ( fO * 112.21) / ( (fO * 112.21) + ((1\text{-}fO) * 28.05) )$$

Characteristic signals corresponding to the incorporation of 1-butene were observed (J. Randall, Macromol. Sci., Rev. Macromol. Chem. Phys. 1989, C29, 201.) and all contents calculated with respect to all other monomers present in the polymer with the limit of quantification being 0.2 mol% of butene.

Characteristic signals resulting from isolated 1-butene incorporation i.e. EEBEE comonomer sequences, were observed. Isolated 1-butene incorporation was quantified using the integral of the signal at 39.8 ppm assigned to the aaB2B2 sites accounting for the number of reporting sites per comonomer:

$$BB = 2 * I_{aaB2B2}$$

When characteristic signals resulting from non-consecutive 1-butene incorporation i.e. EBEBE comonomer sequences were also observed, such non-consecutive 1-butene incorporation was quantified using the integral of the signal at 24.7 ppm assigned to the bbB2B2 sites accounting for the number of reporting sites per comonomer:

$$BEB = 2 * I_{bbB2B2}$$

Due to the overlap of the *B2 and *bB2B2 sites of isolated (EEBEE) and non-consecutively incorporated (EBEBE) 1-butene respectively the total amount of isolated 1-butene incorporation is corrected based on the amount of non-consecutive 1-butene present:

$$B = I_{*B2} - 2 * I_{bbB2B2}$$

With no other signals indicative of other comonomer sequences, i.e. butene chain initiation, observed the total 1-butene comonomer content was calculated based solely on the amount of isolated (EEBEE), consecutive (EBBE) and non-consecutive (EBEBE) 1-butene comonomer sequences:

$$B_{total} = B + BB + BEB$$

Characteristic signals resulting from saturated end-groups were observed. The content of such saturated end-groups was quantified using the average of the integral of the signals at 22.8 and 32.2 ppm assigned to the 2s and 3s sites respectively:

$$S = (1/2)*( I_{2S} + I_{3S} )$$

The relative content of ethylene was quantified using the integral of the bulk methylene (d+) signals at 30.00 ppm:

$$E = (1/2)*I_{d+}$$

The total ethylene comonomer content was calculated based the bulk methylene signals and accounting for ethylene units present in other observed comonomer sequences or end-groups:

$$E_{total} = E + (5/2)*B + (7/2)*BB + (9/2)*BEB + (3/2)*S$$

The total mole fraction of 1-butene in the polymer was then calculated as:

$$fB = B_{total} / ( E_{total} + B_{total} )$$

The total comonomer incorporation of 1-butene in mole percent was calculated from the mole fraction in the usual manner:

$$B\ [mol\%] = 100 * fB$$

The total comonomer incorporation of 1-butene in weight percent was calculated from the mole fraction in the standard manner:

$$B\ [wt\%] = 100 * ( fB * 56.11) / ( (fB * 56.11) + ((1 - fB) * 28.05) )$$

Further information can be found in the following references:

Klimke, K., Parkinson, M., Piel, C., Kaminsky, W., Spiess, H.W., Wilhelm, M., Macromol. Chem. Phys. 2006; 207:382.

Parkinson, M., Klimke, K., Spiess, H.W., Wilhelm, M., Macromol. Chem. Phys. 2007; 208: 2128.

NMR Spectroscopy of Polymers: Innovative Strategies for Complex Macromolecules, Chapter 24, 401 (2011)

Pollard, M., Klimke, K., Graf, R., Spiess, H.W., Wilhelm, M., Sperber, O., Piel, C., Kaminsky, W., Macromolecules 2004;37:813.

Filip, X., Tripon, C., Filip, C., J. Mag. Resn. 2005, 176, 239

Griffin, J.M., Tripon, C., Samoson, A., Filip, C., and Brown, S.P., Mag. Res. in Chem. 2007 45, S1, S198

Castignolles, P., Graf, R., Parkinson, M., Wilhelm, M., Gaborieau, M., Polymer 50 (2009) 2373

Zhou, Z., Kuemmerle, R., Qiu, X., Redwine, D., Cong, R., Taha, A., Baugh,

D. Winniford, B., J. Mag. Reson. 187 (2007) 225

Busico, V., Carbonniere, P., Cipullo, R., Pellecchia, R., Severn, J., Talarico, G., Macromol. Rapid Commun. 2007, 28, 1128

J. Randall, Macromol. Sci., Rev. Macromol. Chem. Phys. 1989, C29, 201

Qiu, X., Redwine, D., Gobbi, G., Nuamthanom, A., Rinaldi, P., Macromolecules 2007, 40, 6879

Liu, W., Rinaldi, P., McIntosh, L., Quirk, P., Macromolecules 2001, 34, 4757

*f) Unsaturation*

Quantitative nuclear-magnetic resonance (NMR) spectroscopy was used to quantify the content of unsaturated groups present in the polymers.

Quantitative $^1$H NMR spectra recorded in the solution-state using a Bruker Avance III 400 NMR spectrometer operating at 400.15 MHz. All spectra were recorded using a $^{13}$C optimised 10 mm selective excitation probehead at 125°C using nitrogen gas for all pneumatics. Approximately 200 mg of material was dissolved in *1,2*-tetrachloroethane-$d_2$ (TCE-$d_2$) using approximately 3 mg of Hostanox 03 (CAS 32509-66-3) as stabiliser. Standard single-pulse excitation was employed utilising a 30 degree pulse, a relaxation delay of 10 s and 10 Hz sample rotation. A total of 128 transients were acquired per spectra using 4 dummy scans. This setup was chosen primarily for the high resolution needed for unsaturation quantification and stability of the vinylidene groups. All chemical shifts were indirectly referenced to TMS at 0.00 ppm using the signal resulting from the residual protonated solvent at 5.95 ppm.

Characteristic signals corresponding to the presence of terminal aliphatic vinyl groups (R-CH=CH$_2$) were observed and the amount quantified using the integral of the two coupled inequivalent terminal CH$_2$ protons (Va and Vb) at 4.95, 4.98 and 5.00 and 5.05 ppm accounting for the number of reporting sites per functional group:

$$Nvinyl = IVab / 2$$

When characteristic signals corresponding to the presence of internal vinylidene groups (RR'C=CH$_2$) were observed the amount is quantified using the integral of the two CH$_2$ protons (D) at 4.74 ppm accounting for the number of reporting sites per functional group:

$$Nvinylidene = ID / 2$$

When characteristic signals corresponding to the presence of internal cis-vinylene groups (E-RCH=CHR'), or related structure, were observed the amount is quantified using the integral of the two CH protons (C) at 5.39 ppm accounting for the number of reporting sites per functional group:

$$Ncis = IC / 2$$

When characteristic signals corresponding to the presence of internal trans-vinylene groups (Z-RCH=CHR') were observed the amount is quantified using the integral of the two CH protons (T) at 5.45 ppm accounting for the number of reporting sites per functional group:

$$Ntrans = IT / 2$$

When characteristic signals corresponding to the presence of internal trisubstituted-vinylene groups (RCH=CHR'R"), or related structure, were observed the amount is quantified using the integral of the CH proton (Tris) at 5.14 ppm accounting for the number of reporting sites per functional group:

$$Ntris = ITris$$

The Hostanox 03 stabliser was quantified using the integral of multiplet from the aromatic protons (A) at 6.92, 6.91, 6.69 and at 6.89 ppm and accounting for the number of reporting sites per molecule:

$$H = IA / 4$$

As is typical for unsaturation quantification in polyolefins the amount of unsaturation was determined with respect to total carbon atoms, even though quantified by $^1$H NMR spectroscopy. This allows direct comparison to other microstructure quantities derived directly from $^{13}$C NMR spectroscopy.

The total amount of carbon atoms was calculated from integral of the bulk aliphatic signal between 2.85 and -1.00 ppm with compensation for the methyl signals from the stabiliser and carbon atoms relating to unsaturated functionality not included by this region:

NCtotal= (Ibulk - 42*H) / 2 + 2*Nvinyl + 2*Nvinilydene + 2*Ncis + 2*Ntrans + 2*Ntris

The content of unsaturated groups (U) was calculated as the number of unsaturated groups in the polymer per thousand total carbons (kCHn):

$$U = 1000*N / NCtotal$$

The total amount of unsaturated group was calculated as the sum of the individual observed unsaturated groups and thus also reported with respect per thousand total carbons:

$$Utotal = Uvinyl + Uvinylidene + Ucis + Utrans + Utris$$

The relative content of a specific unsaturated group (U) is reported as the fraction or percentage of a given unsaturated group with respect to the total amount of unsaturated groups:

$$[U] = Ux / Utotal$$

Further information can be found in the following references:

He, Y., Qiu, X, and Zhou, Z., Mag. Res. Chem. 2010, 48, 537-542

Busico, V. et. al. Macromolecules, 2005, 38 (16), 6988-6996

*g) Melting temperature (Tm) and Crystallization temperature (Tc)*

The melting temperature (Tm) and crystallization temperature (Tc) were determined according to ISO 11357. Experiments were performed with a TA Instruments Q200, calibrated with Indium, Zinc, Tin and according to ISO 11357-3. Roughly 5 mg of material were placed in a pan and tested at 10°C/min throughout the experiments, under 50 mL/min nitrogen flow, with lower and higher temperatures of -30°C and 180°C respectively. Only the second heating run was considered for the analysis. The melting temperature Tm is defined as the temperature of the main peak of the thermogram, while the melting enthalpy ($\Delta$Hm) is calculated by integrating between 10°C and the end of the thermogram, typically Tm+15°C. The running integral in this range is also calculated.

## 2. Materials

a) As ethylene-alpha-olefin copolymer (A) an ethylene-1-octene copolymer was used (octene content 33.7 wt.%) having an $MFR_2$ of 6.7 g/10min, a $FRR_{21/2}$ of 25.3, a density of 870.2 kg/m$^3$, MWD (Mw/Mn) of 2.55 and a melting temperature T of 52.3°C, prepared as described below.

| | |
|---|---|
| Vinyl /100kCHn | 6.0 |
| Vinylidene /100kCHn | 8.9 |
| Tris /100kCHn | 10.0 |
| Vinylene /100kCHn | 3.4 |
| Total unsaturation /100kCHn | 28.3 |
| Vinyl unsaturation degree % | 21.2 |
| Vinylene unsaturation degree % | 12.0 |
| Sum of vinyl and vinylene unsaturation degrees | 33.2 |
| Vinylidene unsaturation degree % | 31.4 |
| Trisubstitued unsaturation (tris) degree % | 35.3 |

The ethylene-1-octene copolymer (A) was produced with Borealis proprietor Borceed™ solution polymerization technology, in the presence of a metallocene catalyst.

The polymerization conditions were selected in such a way that the reacting system is one liquid phase, i.e. the temperature was 170°C and pressure was in the range of 85 to 90 bar.

b) As hydrotalcite compound (B) "DHT-4V LC" commercially available from Kisuma Chemicals BV was used in the examples.

## 3. Results

The above-mentioned ethylene-1-octene copolymer and the hydrotalcit compound as well as 0.1 wt.% of Irganox 1076 have been melt-mixed in a standard co-rotating twin-screw extruder ZSK32MC by Coperion, the extruder had a diameter of 32 mm and length to diameter ratio (L/D) of 48. The barrel temperatures were adjusted to 210 °C. The polymers and additives have been dosed from separate scales into the main hopper of the extruder. Underwater pelletizer with 10 holes having 3 mm diameter was used to pelletize the polymer melt.

The processing conditions are shown in Table 1 below:

Table 1

| Example | Amount hydrotalcite compound (B) / ppm | Extruder speed / rpm | Throughput rate / kg h$^{-1}$ |
|---|---|---|---|
| Inv. Ex. 1 | 5000 | 600 | 110 |
| Inv. Ex. 2 | 5000 | 600 | 50 |
| Inv. Ex. 3 | 5000 | 400 | 80 |
| Inv. Ex. 4 | 2500 | 500 | 40 |
| Inv. Ex. 5 | 2500 | 200 | 40 |
| Inv. Ex. 6 | 5000 | 200 | 25 |
| Inv. Ex. 7 | 5000 | 600 | 110 |
| Inv. Ex. 8 | 5000 | 600 | 50 |
| Inv. Ex. 9 | 2500 | 400 | 80 |
| Inv. Ex. 10 | 2500 | 400 | 40 |
| Inv. Ex. 11 | 2500 | 200 | 40 |
| Inv. Ex. 12 | 17000 | 200 | 25 |
| Comp. Ex. 1 | 0 | 400 | 80 |
| Comp. Ex. 2 | 0 | 400 | 40 |

Results of the VR measurements on these examples of Table 1 are shown in table 2 below. As can be seen from Table 2, the addition of a hydrotalcite compound improves the volume resistance to more than $1 \cdot 10^{15}\,\Omega \cdot cm$, thus qualifying the composition of the inventive examples as encapsulant composition for solar cells and solar modules.

**Table 2** Volume resistivity (VR) in Ω·cm of the examples after 1, 2, 5 and 10 min

| Time (min) | Inv. Ex. 1 | Inv. Ex. 2 | Inv. Ex. 3 | Inv. Ex. 4 | Inv. Ex. 5 | Inv. Ex. 6 | Inv. Ex. 7 | Inv. Ex. 8 | Inv. Ex. 9 | Inv. Ex. 10 | Inv. Ex. 11 | Inv. Ex. 12 | Comp. Ex. 1 | Comp. Ex. 2 |
|---|---|---|---|---|---|---|---|---|---|---|---|---|---|---|
| 1 | 4,50E+15 | 2,90E+15 | 3,30E+15 | 1,90E+15 | 2,61E+15 | 3,30E+15 | 3,80E+15 | 2,70E+15 | 1,46E+15 | 1,33E+15 | 1,46E+15 | 5,75E+15 | 4,32E+14 | 2,20E+14 |
| 2 | 5,60E+15 | 3,60E+15 | 3,90E+15 | 2,30E+15 | 3,14E+15 | 3,80E+15 | 4,40E+15 | 3,50E+15 | 1,87E+15 | 1,70E+15 | 1,93E+15 | 6,86E+15 | 5,89E+14 | 3,00E+14 |
| 5 | 6,90E+15 | 4,30E+15 | 4,40E+15 | 2,80E+15 | 3,92E+15 | 4,50E+15 | 5,20E+15 | 4,80E+15 | 2,09E+15 | 2,08E+15 | 2,05E+15 | 8,30E+15 | 8,50E+14 | 4,80E+14 |
| 10 | 7,10E+15 | 4,60E+15 | 4,80E+15 | 2,90E+15 | 3,90E+15 | 4,80E+15 | 5,10E+15 | 5,00E+15 | 2,07E+15 | 2,98E+15 | 1,86E+15 | 9,26E+15 | 1,09E+15 | 6,30E+14 |

**Claims**

1.  Polyolefin encapsulant composition comprising

    (A) an ethylene-alpha-olefin copolymer, wherein the alpha-olefin has 4 to 8 carbon atoms, and
    (B) a hydrotalcite compound,
    wherein the ethylene- alpha-olefin copolymer (A) has
    a density in the range of 850 kg/m³ to 900 kg/m³ measured according to ISO 1183, and
    a melt flow rate $MFR_2$ in the range of from 0.3 g/10 min to 45 g/10 min measured according to ISO 1133 at 190°C with a load of 2.16 kg, and
    wherein the hydrotalcite compound (B) is present in an amount of from 0.01 to 5 wt.% based on the total weight of the polyolefin encapsulant composition.

2.  The polyolefin encapsulant composition according to claim 1, wherein ethylene-alpha-olefin copolymer (A) is present in an amount of from 90 to 99.95 wt.% based on the total weight of the polyolefin encapsulant composition.

3.  The polyolefin encapsulant composition according to any one of the preceding claims, wherein units originating from the alpha-olefin are present in an amount of 25 to 45 wt.% based on the total weight of the ethylene-alpha-olefin copolymer (A).

4.  The polyolefin encapsulant composition according to claim 1 or 2, wherein the hydrotalcite compound (B) is represented by formula (1)

$$Mg_x R_y^{3+}(OH)_z (CO_3)_k \cdot nH_2O \qquad (1)$$

    wherein $R^{3+}$ is selected from Al, Cr or Fe,
    $4 \leq x \leq 6$, $y = 2$, $6 \leq z \leq 18$, $k = 1$ and $3 \leq n \leq 4$.

5.  The polyolefin encapsulant composition according to any one of the preceding claims, wherein the hydrotalcite compound (B) comprises, or consists of, synthetic hydrotalcite.

6.  The polyolefin encapsulant composition according to any one of the preceding claims, wherein the hydrotalcite compound (B) has a BET surface of from 1 to 20 m²/g determined according to ISO 9277.

7.  The polyolefin encapsulant composition according to any one of the preceding claims, wherein the ethylene-alpha-olefin copolymer (A) has a flow rate ratio $FRR_{21/2}$ of from 20.0 to 45.0 measured according to ISO 1133.

8.  The polyolefin encapsulant composition according to any of the preceding claims, wherein the ethylene-alpha-olefin copolymer (A) has a Mw/Mn of from 1.0 to 6.0 determined by Gel Permeation Chromatography.

9.  The polyolefin encapsulant composition according to any one of the preceding claims, wherein the polyolefin encapsulant composition does not comprise an organic peroxide.

10. The polyolefin encapsulant composition according to any one of the preceding claims, wherein the ethylene-alpha-olefin (A) has

    a) 1.0 to 20.0 vinyl unsaturation units /100,000 C atoms measured by ¹H NMR, and/or
    b) 5.0 to 30.0 vinylidene unsaturation units /100,000 C atoms measured by ¹H NMR,
    c) 2.0 to 15.0 vinylene unsaturation units /100,000 C atoms measured by ¹H NMR,
    d) 5.0 to 35.0 trisubstituted unsaturation units / 100,000 C atoms measured by ¹H NMR,
    e) 15.0 to 100.0 total unsaturation units /100,000 C atoms, wherein the total unsaturation units /100,000 C atoms is the sum of vinyl unsaturation units /100,000 C atoms, vinylidene unsaturation units /100,000 C atoms, vinylene unsaturation units /100,000 C atoms and trisubstituted unsaturation units /100,000 C atoms, all measured by ¹H NMR.

11. The polyolefin encapsulant composition according to any one of the preceding claims, wherein the ethylene-alpha-olefin copolymer (A) has

f) an unsaturation degree according to formula (2)

$$unsaturation_{Type}\ degree\ (\%) =$$

$$\frac{unsaturation_{Type}\ units\ /\ 100{,}000\ C\ atoms}{total\ unsaturation\ units/100{,}000\ C\ atoms} * 100 \qquad (2)$$

wherein

a vinyl unsaturation degree is in the range of from 7.0 to 27.0 %, preferably of from 10.0 to 24.0 %,
a vinylene unsaturation degree is in the range of from 5.0 to 18.0 %, preferably of from 6.0 to 15.0%, and
wherein the sum of the vinyl unsaturation degree and vinylidene unsaturation degree is in the range of from 30.0%
up to 60.0%.

12. The polyolefin encapsulant composition according to claim 11, wherein the vinylidene unsaturation degree is in the range of from 25.0 to 38.0 %, and/or wherein the trisubstituted unsaturation degree is in the range of from 30.0 to 45.0 %.

13. The polyolefin encapsulant composition according to any one of the preceding claims, wherein the alpha-olefin has 4 or 8 carbon atoms, preferably wherein the alpha-olefin is 1-butene or 1-octene, more preferably 1-octene.

14. Article comprising the polyolefin encapsulant composition according to any one of the preceding claims, whereby the article is preferably a solar module.

15. Use of a hydrotalcite compound (B) for improving the volume resistivity of a polyolefin encapsulant composition comprising an ethylene-alpha-olefin copolymer (A), wherein the hydrotalcite compound (B) is preferably present in an amount of from 0.01 to 5 wt.% based on the total weight of the polyolefin encapsulant composition.

## EUROPEAN SEARCH REPORT

**Application Number**

EP 24 18 0468

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2015 211189 A (JAPAN POLYETHYLENE CORP) 24 November 2015 (2015-11-24) | 1,4,5,9, 10,13-15 | INV. C08K3/26 |
| A | * examples 1-7 * | 2,3,6-8, 11,12 | C08L23/08 H01L31/048 |
| | ----- | | |
| X | WO 2013/186992 A1 (MITSUI CHEMICALS TOHCELLO INC [JP]) 19 December 2013 (2013-12-19) | 1,2,4,5, 9,13-15 | |
| A | * examples 2,4 * | 3,6-8, 10-12 | |
| | ----- | | |

**TECHNICAL FIELDS SEARCHED (IPC)**

C08K
C08L
H01L

The present search report has been drawn up for all claims

| Place of search | Date of completion of the search | Examiner |
|---|---|---|
| Munich | 7 November 2024 | Ritter, Nicola |

## ANNEX TO THE EUROPEAN SEARCH REPORT
## ON EUROPEAN PATENT APPLICATION NO.

EP 24 18 0468

This annex lists the patent family members relating to the patent documents cited in the above-mentioned European search report.
The members are as contained in the European Patent Office EDP file on
The European Patent Office is in no way liable for these particulars which are merely given for the purpose of information.

07-11-2024

| Patent document cited in search report | Publication date | Patent family member(s) | Publication date |
|---|---|---|---|
| JP 2015211189 A | 24-11-2015 | NONE | |
| WO 2013186992 A1 | 19-12-2013 | CN 104334631 A | 04-02-2015 |
| | | JP 5922232 B2 | 24-05-2016 |
| | | JP WO2013186992 A1 | 04-02-2016 |
| | | TW 201402665 A | 16-01-2014 |
| | | WO 2013186992 A1 | 19-12-2013 |

EPO FORM P0459

For more details about this annex : see Official Journal of the European Patent Office, No. 12/82

## REFERENCES CITED IN THE DESCRIPTION

### Patent documents cited in the description

- WO 2013186992 A
- WO 2012150285 A
- WO 2012150287 A
- WO 2012150286 A

### Non-patent literature cited in the description

- **KLIMKE, K.** ; **PARKINSON, M.** ; **PIEL, C.** ; **KAMINSKY, W.** ; **SPIESS, H.W.** ; **WILHELM, M.** *Macromol. Chem. Phys.*, 2006, vol. 207, 382
- **PARKINSON, M.** ; **KLIMKE, K.** ; **SPIESS, H.W.** ; **WILHELM, M**. *Macromol. Chem. Phys.*, 2007, vol. 208, 2128
- NMR Spectroscopy of Polymers: Innovative Strategies for Complex Macromolecules. 2011, 401
- **POLLARD, M.** ; **KLIMKE, K.** ; **GRAF, R.** ; **SPIESS, H.W.** ; **WILHELM, M.** ; **SPERBER, O.** ; **PIEL, C.** ; **KAMINSKY, W.** *Macromolecules*, 2004, vol. 37, 813
- **FILIP, X.** ; **TRIPON, C.** ; **FILIP, C.** *J. Mag. Resn.*, 2005, vol. 176, 239
- **GRIFFIN, J.M.** ; **TRIPON, C.** ; **SAMOSON, A.** ; **FILIP, C.** ; **BROWN, S.P.** *Mag. Res. in Chem.*, 2007, vol. 45 (S1), S198
- **CASTIGNOLLES, P.** ; **GRAF, R.** ; **PARKINSON, M.** ; **WILHELM, M.** ; **GABORIEAU, M.** *Polymer*, 2009, vol. 50, 2373
- **ZHOU, Z., KUEMMERLE, R., QIU, X., REDWINE, D., CONG, R., TAHA, A., BAUGH, D. WINNIFORD, B.** *J. Mag. Reson.*, 2007, vol. 187, 225
- **BUSICO, V.** ; **CARBONNIERE, P** ; **CIPULLO, R.** ; **PELLECCHIA, R.** ; **SEVERN, J.** ; **TALARICO, G.** *Macromol. Rapid Commun.*, 2007, vol. 28, 1128
- **J. RANDALL**. *Macromol. Sci., Rev. Macromol. Chem. Phys.*, 1989, vol. C29, 201
- **QIU, X.** ; **REDWINE, D.** ; **GOBBI, G.** ; **NUAMTHANOM, A.** ; **RINALDI, P.** *Macromolecules*, 2007, vol. 40, 6879
- **LIU, W.** ; **RINALDI, P.** ; **MCINTOSH, L.** ; **QUIRK, P.** *Macromolecules*, 2001, vol. 34, 4757
- *CHEMICAL ABSTRACTS*, 32509-66-3
- **HE, Y.** ; **QIU, X** ; **ZHOU, Z.** *Mag. Res. Chem.*, 2010, vol. 48, 537-542
- **BUSICO, V.** *Macromolecules*, 2005, vol. 38 (16), 6988-6996